# EUROPEAN PATENT SPECIFICATION

(11) **EP 2 533 064 B1**
(45) Date of publication and mention of the grant of the patent: **08.05.2019**
(21) Application number: 11191646.6
(22) Date of filing: 02.12.2011
(51) Int. Cl.: G01R 31/36, G06F 1/32

(54) **Apparatus and method for determining a remaining battery life of a portable terminal**
Vorrichtung und Verfahren zur Bestimmung der verbleibenden Batterielebensdauer eines tragbaren Endgerätes
Appareil et procédé pour déterminer la durée de vie restante d'une batterie d'un terminal portable

(30) Priority: 10.06.2011 KR 20110056375
(43) Date of publication of application: 12.12.2012
(73) Proprietor: Samsung Electronics Co., Ltd., Suwon-si, Gyeonggi-do, 443-742 (KR)
(72) Inventor: Choi, Jong-Hun, 442-742 Gyeonggi-do (KR); Yang, Hun-Woong, 442-742 Gyeonggi-do (KR)
(74) Representative: Nederlandsch Octrooibureau

(56) References cited:
- EP-A2- 2 219 095
- US-A1- 2004 215 408
- US-A1- 2008 036 904
- US-A1- 2010 229 117

## Description

### BACKGROUND OF THE INVENTION

### Field of the Invention

The present invention relates to an apparatus and method for determining the remaining life of a battery in a portable terminal, and more particularly, to an apparatus and method for determining the residual battery life of a portable terminal when the portable terminal is power off.

### Description of the Related Art

The most challenging issue with portable terminals including smart phones is that the portable terminals can be used for a limited operation time due to limited battery capacity.

Accordingly, users increasingly need to check the power remained in the terminals. To avoid getting into running out of battery power, users should be able to detect the remaining battery power at any time.

In general, when a portable terminal is in a power-on state, a battery bar displayed on a display to indicate the percentage of battery left in the portable terminal.

If the portable terminal is power off, a user can transition the portable terminal to a charge mode by connecting it to a charger or a Universal Serial Bus (USB) cable, and the user reads the remaining battery life time from a battery icon.

During the power off mode, the user must boot the portable terminal without a charger or a USB cable coupled thereto for determining the remaining battery life. However, the booting takes tens of seconds or a few minutes after power-on in some terminals.

If a user wants to replace a discharged battery with another one, he or she must boot the portable terminal with the replacement in order to compare the remaining life of the existing battery with that of the replacement.

In case of a plurality of batteries, the user must boot the portable terminal with the individual batteries one by one to select a battery with the greatest residual quantity.

If the user powers off the portable terminal to save power, the user's booting of the portable terminal to check its remaining battery life contributes to unnecessary power consumption. Moreover, there is no way to check the remaining battery life when powering the portable terminal is not convenient in some instances.

US 2004/215 408 A1 discloses a camera with a display. In a power off state of the camera, in response to the activation of a status button, operating power is applied to the display and a limited set of other operational components, to enable the display of various operational parameters. One such parameter is the estimated remaining battery life of the battery used to power the camera, which is calculated based on a stored battery life value and the amount of time that has passed since the value was stored.

US 2008/036 904 A1 discloses a camera which, when it is turned on, estimates a remaining battery life in the battery and starts the booting process on the condition that the calculated remaining battery life is sufficient.

EP 2 219 095 A2 discloses a notebook computer with status indicator lights for indicating a battery status. In a shutdown mode of the notebook computer, if a function key is pressed, a controller can read data about a battery capacity and indicate said capacity through the indicator lights.

US 2010/0229117 A1 discloses a method of displaying information of a portable device, which includes receiving a signal of booting or termination of the portable device; and displaying a valid information which is previously set while the booting or termination process is performing.

### SUMMARY OF THE INVENTION

An aspect of embodiments of the present invention is to address at least the problems and/or disadvantages and to provide at least the advantages described below. Accordingly, an aspect of embodiments of the present invention is to provide an apparatus and method for determining the remaining battery time in a portable terminal when the portable terminal is in a power-off state.

Another aspect of embodiments of the present invention is to provide an apparatus and method for determining the remaining battery life in a portable terminal without booting the portable terminal.

A further aspect of embodiments of the present invention is to provide an apparatus and method for determining the percentage of remaining battery life in a portable terminal, without connecting a charger or a Universal Serial Bus (USB) cable to the portable terminal.

In accordance with an aspect of the present invention, there is provided an apparatus for determining a residual battery quantity in a portable terminal as described in claim 1.

In accordance with another aspect of the present invention, there is provided a method for determining a remaining battery time in a portable terminal, as described in claim 4.

In accordance with an embodiment of the present invention, a terminal for indicating a remaining battery life includes an apparatus for determining a residual battery quantity as described above.

### BRIEF DESCRIPTION OF THE DRAWINGS

The above features and advantages of certain embodiments of the present invention will be more apparent from the following detailed description taken in conjunction with the accompanying drawings, in which:
FIG. 1 is a block diagram of a portable terminal according to an embodiment of the present invention;
FIG. 2 is a flowchart illustrating an operation for determining the residual quantity of a battery in the portable terminal according to an embodiment of the present invention; and
FIG. 3 is a view referred to for describing indication of a residual battery quantity in the portable terminal according to an embodiment of the present invention.

Throughout the drawings, the same drawing reference numerals will be understood to refer to the same elements, features and structures.

### DETAILED DESCRIPTION

Reference will now be made in detail to the preferred embodiments of the present invention with reference to the accompanying drawings. For the purposes of clarity and simplicity, a detailed description of a generally known function and structure of the present invention will be avoided as it obscure the subject matter of the present invention.

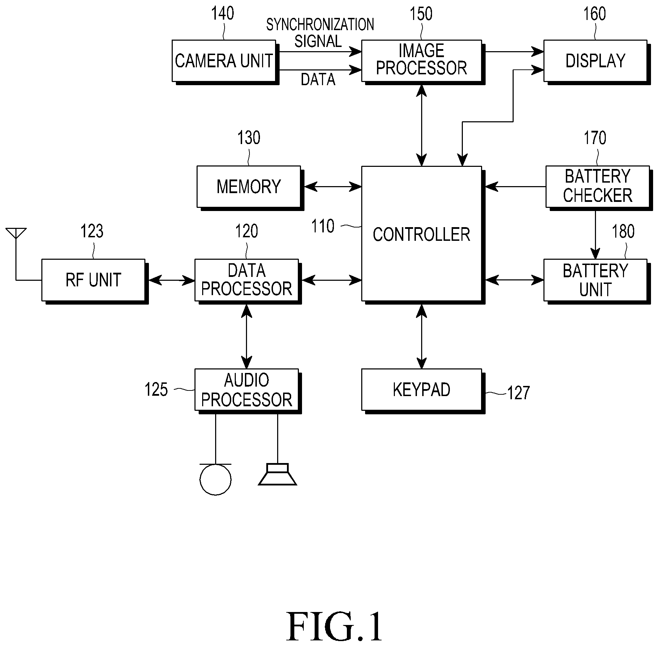

FIG. 1 is a block diagram of a portable terminal according to an embodiment of the present invention.

Referring to FIG. 1, a Radio Frequency (RF) unit 123 performs a wireless communication function for the portable terminal. The RF unit 123 includes an RF transmitter for upconverting the frequency of a transmission signal and amplifying the upconverted transmission signal and an RF receiver for low-noise-amplifying a received signal and downconverting the frequency of the low-noise-amplified signal.

A data processor 120 includes a transmitter for encoding and modulating the transmission signal and a receiver for demodulating and decoding the received signal. That is, the data processor 120 may include a MODEM and a CODEC. The CODEC includes a data CODEC for processing packet data and an audio CODEC for processing an audio signal such as voice.

An audio processor 125 reproduces a received audio signal output from the audio CODEC of the data processor 120 or transmits a transmission audio signal generated from a microphone to the audio CODEC of the data processor 120.

A memory 130 may include a program memory and a data memory. The program memory may store programs required to control typical operations of the portable terminal and a program required for determining the battery power of the portable terminal without booting the portable terminal.

A keypad 127 includes alphanumerical keys for inputting digits and characters and function keys for setting various functions.

In accordance with the embodiment of the present invention, the keypad 127 further includes a power key and a predetermined key for transitioning the portable terminal to a residual battery indication mode during a power-off state of the portable terminal. The predetermined key may be an existing key such as a home key, a volume key, or a capture key, or a separately procured key in the portable terminal.

A controller 110 provides overall control to the portable terminal.

In accordance with the embodiment of the present invention, upon input of the power key while the predetermined key is being input during the power-off state of the portable terminal, the controller 110 enters into the residual battery indication mode. In the residual battery indication mode, the controller 10 controls activation of only a battery checker 170 for checking the remaining battery life and displays it in a display 160. A general portable terminal can display the remaining battery life with bars using the battery checker.

The controller 110 has a User Interface (UI) function for displaying the remaining battery life on the display 160 in the residual battery indication mode in the embodiment of the present invention.

In addition, the controller 110 may have a battery check function for checking the remaining battery time during the residual battery indication mode according to an embodiment of the present invention. In this case, the battery checker 170 may not be provided in the portable terminal.

Upon receipt of the power key while the predetermined key is being input during the power-off state of the portable terminal, the battery checker 170 checks the residual time of a battery unit 180 and the battery unit 180 supplies power to the portable terminal. And, the portable terminal is turned on and the battery check unit and the display unit are also activated at the same time by pushing only another predetermined key, without pushing the power key. When simultaneously pushing the power key and another predetermined key, the portable terminal is turned on by pushing the power key, and only the battery check unit and display unit are activated by pushing another predetermined key.

A camera unit 140 includes a camera sensor for capturing an image and converting the captured optical signal to an electrical signal, and a signal processor for converting the analog image signal captured through the camera sensor to digital data. Herein, the camera sensor is assumed to be a Charge Coupled Device (CCD) or Complementary Metal Oxide Semiconductor (CMOS) sensor and the signal processor may be configured into a Digital Signal Processor (DSP). The camera sensor and the signal processor may be incorporated into a single device or separately configured.

An image processor 150 performs Image Signal processing (ISP) to display an image signal received from the camera unit 140 on a display 160. The ISP involves functions such as gamma correction, interpolation, spatial change, image effects, image scaling, Auto White Balance (AWB), Auto Exposure (AE), Auto Focus (AF), etc. Therefore, the image processor 150 processes the image signal received from the camera unit 140 on a frame basis and outputs the frame image data according to the characteristics and size of the display 160. The image processor 150 includes a video CODEC for compressing frame image data to be displayed on the display 160 in a predetermined scheme or decompressing compressed frame image data to the original frame image data. The video CODEC may be a JPEG CODEC, an MPEG4 CODEC, or a Wavelet CODEC. It is assumed herein that the image processor 150 is equipped with an On Screen Display (OSD) function, and the image processor 150 may output OSD data according to the size of a displayed screen under the control of the controller 110.

The display 160 displays the image signal received from the image processor 150 on a screen and also displays user data received from the controller 110. The display 160 may be configured with a Liquid Crystal Display (LCD). In this case, the display 160 may include an LCD controller, a memory for storing image data, and an LCD device. If the LCD is configured into a touch screen, it may serve as an input unit. Thus, the display 160 may display the same keys as those of the keypad 127.

According to the embodiment of the present invention, the display 160 displays a residual battery time during the residual battery indication mode.

The display 160 may further display a booting menu for transitioning to a booting mode and an end menu for powering off the portable terminal, together with the residual battery quantity in the residual battery quantity indication mode.

If the display 160 operates in a touch screen fashion, the booting menu or the end menu may be selected by touching the display 160. Otherwise, the controller 110 may control selection of the booting menu or the end menu by activating the keypad 127.

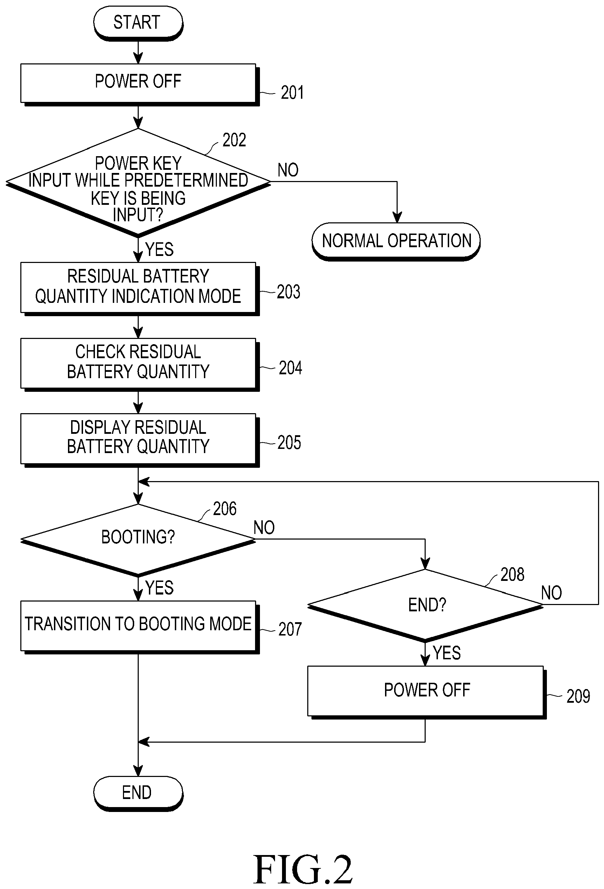

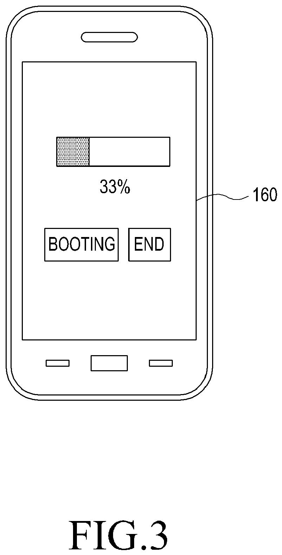

Now a detailed description will be given of an operation for determining and displaying a residual battery quantity in the portable terminal with reference to FIGs. 2 and 3.

FIG. 2 is a flowchart illustrating an operation for determining the remaining percentage of battery life or time in the portable terminal according to an embodiment of the present invention.

Referring to FIG. 2, the portable terminal is power off in step 201. Upon receipt of the power key while the predetermined key is being input in the power-off state in step 202, the controller 110 transitions to the residual battery indication mode in step 203.

In the residual battery quantity mode, the controller 110 controls activation of only the battery checker 170 for checking a remaining battery life and the display 160 for displaying the remaining battery time.

The activated battery checker 170 checks a current remaining battery life and transmits the information to the controller 110 in step 204.

Upon receipt of the information about the current remaining battery life, the controller 110 controls the activated display 160 to display the remaining battery life in step 205.

Specifically, the controller 110 may indicate the remaining battery life in various manners, for example, in the form of a battery bar or a value on the display 160.

The controller 110 further displays a booting menu for transitioning to the booting mode and an end menu for powering off the portable terminal, together with the remaining battery life on the display 160.

Upon selection of the booting menu on the display 160 by touch in step 206, the controller 110 transitions the portable terminal to the booting mode in step 207. On the other hand, upon selection of the end menu on the display 160 by touch in step 208, the controller 110 powers off the portable terminal in step 209.

FIG. 3 is a view referred to for describing indication of a residual battery quantity in the portable terminal according to an embodiment of the present invention.

Referring to FIG. 3, a current remaining battery life is indicated by a battery bar on the display 160. Together with the battery bar, a booting menu for entering into the booting mode and an end menu for powering off the portable terminal are also displayed.

A user can identify the current remaining battery life without booting the portable terminal by the operation illustrated in FIG. 2.

If the user has a plurality of batteries, he or she may check the remaining life of a current battery and then power off the portable terminal by selecting the end menu. Then, the user may install another battery to the portable terminal and can also check the residual quantity of the replacement by the operation of FIG. 2.

Meanwhile, after checking the current remaining battery life, the user may directly switch the portable terminal to the booting mode by powering on the portable terminal through a selection of the booting menu.

As is apparent from the above description, the apparatus and method for determining a remaining battery life of a portable terminal according to the present invention enables a user to readily identify the percentage of remaining battery life without booting the portable terminal during the power off mode.

The above-described methods according to the present invention can be implemented in hardware, firmware or as software or computer code that can be stored in a recording medium such as a CD ROM, an RAM, a floppy disk, a hard disk, or a magneto-optical disk or computer code downloaded over a network originally stored on a remote recording medium or a non-transitory machine readable medium and to be stored on a local recording medium, so that the methods described herein can be rendered in such software that is stored on the recording medium using a general purpose computer, or a special processor or in programmable or dedicated hardware, such as an ASIC or FPGA. As would be understood in the art, the computer, the processor, microprocessor controller or the programmable hardware include memory components, e.g., RAM, ROM, Flash, etc. that may store or receive software or computer code that when accessed and executed by the computer, processor or hardware implement the processing methods described herein. In addition, it would be recognized that when a general purpose computer accesses code for implementing the processing shown herein, the execution of the code transforms the general purpose computer into a special purpose computer for executing the processing shown herein.

While the present invention has been particularly shown and described with reference to embodiments thereof, it will be understood by those of ordinary skill in the art that various changes in form and details may be made therein without departing from the scope of the present invention as defined by the following claims.

## Claims

1. An apparatus for determining a remaining power of a battery of a portable terminal, comprising:
a display (160);
an input unit (127, 160) for receiving an input of a predetermined key during a power-off state of the portable terminal without a power-on ;
a battery checker (170) for, upon receipt of the predetermined key, checking the remaining power of the battery of the portable terminal ; and
a controller (110),
wherein the controller (110) is configured to:
in response to receiving the input of the predetermined key, control the display (160) to display the remaining power of the battery on a screen of the display(160) without the power-on,
control the display(160) to display a menu item for performing the booting of the portable terminal on the screen while displaying the remaining power of the battery, and
in response to selection of the displayed menu item on the screen, perform the booting of the portable terminal.

2. The apparatus of claim 1, wherein upon receipt of the predetermined key during the power-off state of the portable terminal, the controller (110) is configured to control transitioning of the portable terminal to a residual battery indication mode and control activation of the batter checker.

3. The apparatus of claim 1, wherein, in response to a selection of end while displaying the remaining power of the battery, the controller (110) is configured to power off the portable terminal.

4. A method for determining a remaining power of a battery of a portable terminal, the method comprising:
receiving (202) an input of a predetermined key during a power-off state of the portable terminal without a power-on;
in response to receiving the input of the predetermined key, obtaining (203) the remaining power of the battery of the portable terminal;
in response to receiving the input of the predetermined key, controlling a display (160) of the portable terminal to display the remaining power of the battery on a screen of the display (160) without the power-on;
controlling the display(160) to display a menu item for performing the booting of the portable terminal on the screen while displaying the remaining power of the battery, and
in response to selection of the displayed menu item on the screen, performing the booting of the portable terminal.

5. The method of claim 4, further comprising, upon a selection of end while displaying the remaining power of the battery, powering off the portable terminal.

## Patentansprüche

1. Vorrichtung zum Bestimmen einer verbleibenden Leistung eines Akkus eines tragbaren Endgeräts, umfassend:
eine Anzeige (160);
eine Eingabeeinheit (127, 160) zum Empfangen einer Eingabe eines vorbestimmten Schlüssels während eines ausgeschalteten Zustands des tragbaren Endgeräts ohne ein Einschalten;
eine Akkuprüfeinrichtung (170) zum Prüfen der verbleibenden Leistung des Akkus des tragbaren Endgeräts beim Empfang des vorbestimmten Schlüssels; und
eine Steuerung (110),
wobei die Steuerung (110) ausgelegt ist zum:
in Ansprechen auf das Empfangen der Eingabe des vorbestimmten Schlüssels Steuern der Anzeige (160), um die verbleibende Leistung des Akkus auf einem Bildschirm der Anzeige (160) ohne das Einschalten anzuzeigen,
Steuern der Anzeige (160), um ein Menüelement zum Durchführen des Hochfahrens des tragbaren Endgeräts auf dem Bildschirm anzuzeigen, während die verbleibende Leistung des Akkus angezeigt wird, und
in Ansprechen auf die Auswahl des angezeigten Menüelements auf dem Bildschirm Durchführen des Hochfahrens des tragbaren Endgeräts.

2. Vorrichtung nach Anspruch 1, wobei beim Empfang des vorbestimmten Schlüssels während des ausgeschalteten Zustands des tragbaren Endgeräts die Steuerung (110) ausgelegt ist, um den Übergang des tragbaren Endgeräts in einen Restakku-Anzeigemodus zu steuern und die Aktivierung der Akkuprüfeinrichtung zu steuern.

3. Vorrichtung nach Anspruch 1, wobei, in Ansprechen auf eine Auswahl eines Endes, während die verbleibende Leistung des Akkus angezeigt wird, die Steuerung (110) ausgelegt ist, um das tragbare Endgerät auszuschalten.

4. Verfahren zum Bestimmen einer verbleibenden Leistung eines Akkus eines tragbaren Endgeräts, das Verfahren umfassend:
Empfangen (202) einer Eingabe eines vorbestimmten Schlüssels während eines ausgeschalteten Zustands des tragbaren Endgeräts ohne ein Einschalten;
in Ansprechen auf das Empfangen der Eingabe des vorbestimmten Schlüssels Erhalten (203) der verbleibenden Leistung des Akkus des tragbaren Endgeräts;
in Ansprechen auf das Empfangen der Eingabe des vorbestimmten Schlüssels Steuern einer Anzeige (160) des tragbaren Endgeräts, um die verbleibende Leistung des Akkus auf einem Bildschirm der Anzeige (160) ohne das Einschalten anzuzeigen;
Steuern der Anzeige (160), um ein Menüelement zum Durchführen des Hochfahrens des tragbaren Endgeräts auf dem Bildschirm anzuzeigen, während die verbleibende Leistung des Akkus angezeigt wird, und
in Ansprechen auf die Auswahl des angezeigten Menüelements auf dem Bildschirm Durchführen des Hochfahrens des tragbaren Endgeräts.

5. Verfahren nach Anspruch 4, ferner umfassend das Ausschalten des tragbaren Endgeräts bei einer Auswahl eines Endes, während die verbleibende Leistung des Akkus angezeigt wird.

## Revendications

1. Appareil pour déterminer une charge restante d'une batterie d'un terminal portable, comprenant :
un afficheur (160) ;
une unité de saisie (127, 160) pour recevoir une entrée d'une touche prédéterminée pendant un état hors tension du terminal portable sans mise sous tension ;
un testeur de batterie (170) pour, à réception de la touche prédéterminée, vérifier la charge restante de la batterie du terminal portable ; et
un contrôleur (110),
dans lequel le contrôleur (110) est configuré pour :
en réponse à la réception de l'entrée de la touche prédéterminée, contrôler l'afficheur (160) pour afficher la charge restante de la batterie sur un écran de l'afficheur (160) sans la mise sous tension,
contrôler l'afficheur (160) pour afficher un élément de menu pour réaliser le lancement du terminal portable à l'écran tout en affichant la charge restante de la batterie, et
en réponse à la sélection de l'élément de menu affiché à l'écran, réaliser le lancement du terminal portable.

2. Appareil selon la revendication 1, dans lequel, à réception de la touche prédéterminée pendant l'état hors tension du terminal portable, le contrôleur (110) est configuré pour contrôler le passage du terminal portable à un mode d'indication de batterie restante et contrôler l'activation du testeur de batterie.

3. Appareil selon la revendication 1, dans lequel, en réponse à une sélection de fin tout en affichant la charge restante de la batterie, le contrôleur (110) est configuré pour mettre le terminal portable hors tension.

4. Procédé pour déterminer une charge restante d'une batterie d'un terminal portable, le procédé comprenant :
la réception (202) d'une entrée d'une touche prédéterminée pendant un état hors tension du terminal portable sans mise sous tension ;
en réponse à la réception de l'entrée de la touche prédéterminée, l'obtention (203) de la charge restante de la batterie du terminal portable ;
en réponse à la réception de l'entrée de la touche prédéterminée, le contrôle d'un afficheur (160) du terminal portable pour afficher la charge restante de la batterie sur un écran de l'afficheur (160) sans la mise sous tension ;
le contrôle de l'afficheur (160) pour afficher un élément de menu pour réaliser le lancement du terminal portable à l'écran tout en affichant la charge restante de la batterie, et
en réponse à la sélection de l'élément de menu affiché à l'écran, la réalisation du lancement du terminal portable.

5. Procédé selon la revendication 4, comprenant en outre, à la sélection de fin tout en affichant la charge restante de la batterie, la mise hors tension du terminal portable.
